# EUROPEAN PATENT APPLICATION

(11) **EP 4 660 211 A1**
(43) Date of publication of application: **10.12.2025**
(21) Application number: 24750006.9
(22) Date of filing: 22.01.2024
(51) Int. Cl.: C08F 290/04, C08F 290/12, C09J 4/02, H01L 21/304

(54) **COMPOSITION FOR TEMPORARY FIXATION, ADHESIVE FOR TEMPORARY FIXATION, AND METHOD FOR PRODUCING THIN WAFER**

(30) Priority: 31.01.2023 JP 2023013520
(71) Applicant: Denka Company Limited, Tokyo 103-8338 (JP)
(72) Inventor: TANIGAWA HOSHINO, Takako, Tokyo 103-8338 (JP); TAKAHASHI, Yusuke, Tokyo 103-8338 (JP); YAMAMOTO, Shota, Tokyo 103-8338 (JP); KURIMURA, Hiroyuki, Tokyo 103-8338 (JP)
(74) Representative: Hoffmann Eitle
(86) International application number: PCT/JP2024/001571
(87) International publication number: WO 2024/162053

(57) **Abstract**

A problem to be solved by the invention is to provide a composition for temporary fixation that can suppress re-adhesion. The above problem can be solved by a composition for temporary fixation containing the following (A) to (C): (A) a polymerizable component containing a (meth)acrylate having an acryloyl group in a side chain (A-1) or a (meth)acrylate having an acryloyl group at both ends of a molecular chain (A-2); (B) a photo-radical polymerization initiator; and (C) an ultraviolet absorber having a polymerizable functional group.

## Description

### Technical Field

The present invention relates to a composition for temporary fixation, an adhesive for temporary fixation, and a method for producing a thin wafer.

### Background Art

In producing an electronic device, a wafer-form substrate having a thickness of about several hundred µm is frequently used, which is obtained by using an inorganic material represented by silicon as a substrate and forming an insulation film on the surface of the substrate, forming a circuit and reducing the thickness by grinding. However, since a substrate is often made of a brittle and fragile material, it is necessary to take a measure for preventing breakage of the substrate, particularly in a thinning process by grinding. The measure conventionally employed is a method of applying a protective tape for temporary fixation, which can be peeled off after completion of a processing step, to an opposite surface (also referred to as a rear surface) to the surface to be ground. The tape, since an organic resin film is used as a base-material, is flexible but insufficient in strength and heat resistance. Thus, the tape is not suitable for use in a step performed at a high temperature.

Then, it has been proposed to use a system that provides sufficient durability to the conditions of a rear-surface grinding step or a rear-electrode formation step by bonding a substrate for an electronic device to a support made of, e.g., silicon or glass with an adhesive interposed between them. In this case, what is important is an adhesive layer for bonding the substrate to the support. The adhesive is required to bond the substrate to the support without space, and have sufficient durability to endure subsequent steps, and finally allows the wafer reduced in thickness to easily peel off from the support. In other words, it is required that the adhesive can temporarily fix the substrate.

Such water processing mainly has a spin coating step, a vacuum bonding and photocuring step, a thinning step by grinding/polishing, a high-temperature processing step, a laser-peeling step, and a removal step of a temporary fixing agent (hereinafter, sometimes referred to as a composition for temporary fixation or an adhesive for temporary fixation).

In the spin coating step, in order to uniformly form a film of a temporary fixing agent on a wafer, it is required that the temporary fixing agent has an appropriate viscosity and is a Newtonian fluid (or has shear viscosity independent of shear rate).

In the vacuum bonding/UV curing step, it is required that a temporary fixing agent be curable on a support made of, e.g., glass, upon irradiation with light such as ultraviolet (UV) in a short time with less outgassing (low-outgassing characteristics).

In the thinning step by grinding/polishing, in order to avoid breakage caused by local application of a grinder load to the substrate, the temporary fixing agent is required to have an appropriate hardness enough to maintain flatness by dispersing the load in the in-plane direction to prevent local depression of the substrate. In addition, it is required that the temporary fixing agent be adhesive to a support, and have an appropriately high elastic modulus for protecting edges and chemical resistance.

In the high-temperature processing step, the temporary fixing agent is required to have heat resistance sufficient to endure high-temperature processing in vacuum for a long time (for example, at 300°C or more for one hour or more).

In the peeling step by laser, it is required that the temporary fixing agent can be peeled off at high speed by a laser such as a UV laser.

In the removal step, it is required that the temporary fixing agent has not only an easy-to-peel property, that is, a property that allows a substrate to peel off from a support, but also an aggregation property and easy-to-washable property to avoid adhesive residue left on the substrate after peeling.

In view of such a background, for example, Patent Literature 1 discloses a composition for temporary fixation containing (A-1) a monofunctional (meth)acrylate whose side chain is an alkyl group having 18 or more carbon atoms and whose homopolymer has a Tg of -100°C to 60°C, and (A-2) a polyfunctional (meth)acrylate, (B) a polyisobutene homopolymer and/or a polyisobutene copolymer, and(C) a photo-radical polymerization initiator, and appeals that the composition is excellent in heat resistance, low-outgassing characteristics, and peel property.

### Citation List

### Patent Literature

Patent Literature 1: WO 2021/235406 A

### Summary of Invention

### Technical Problem

When a temporary fixing agent (that is, the adhesive layer) cured on a wafer is peeled off, a laser is applied in a sweep through a transparent support made of, e.g., glass, to decompose the irradiated sites of the temporary fixing agent to make holes (recesses covered with a support). When the gas vaporizes within holes and expands at a high temperature, the support is pushed up and comes to be easily peeled off.

However, during the period from the laser irradiation to peeling of the glass support and the wafer, the glass support comes into contact with the wafer by its own weight of the glass support, and the glass support and the wafer sometimes re-adhere due to the adhesiveness of a low molecular weight component produced by decomposition of the temporary fixing agent. When re-adhesion occurs, the peel property deteriorates and workability decreases.

The invention was achieved in consideration of the above problems. An object of the invention, in one embodiment, is to provide a composition for temporary fixation that can suppress re-adhesion. In another embodiment, an object of the invention is to provide an adhesive for temporary fixation containing the aforementioned composition for temporary fixation, and a method for producing a thin wafer using the adhesive for temporary fixation.

### Solution to Problem

As a result of intensive studies, the present inventors found that the above problems can be solved by containing a (meth)acrylate having an acryloyl group in a side chain and/or a (meth)acrylate having an acryloyl group at both ends of a molecular chain thereof as a polymerizable component. The invention was achieved based on the above findings, and is disclosed below.

[1]
   A composition for temporary fixation containing the following (A) to (C):
   (A) a polymerizable component containing the following (A-1) or (A-2):
   (A-1) a (meth)acrylate containing an acryloyl group in a side chain; and
   (A-2) a (meth)acrylate having an acryloyl group at both ends of a molecular chain thereof;
   (B) a photo-radical polymerization initiator; and
   (C) an ultraviolet absorber having a polymerizable functional group.
[2]
   The composition for temporary fixation according to [1], in which the composition for temporary fixation has a viscosity of 500 mPa·s to 15,000 mPa·s.
[3]
   The composition for temporary fixation according to [1] or [2], in which the component (A-1) or (A-2) has a Tg of -80°C to 0°C.
[4]
   The composition for temporary fixation according to any one of [1] to [3], in which the component (A-1) or the component (A-2) has a weight average molecular weight of 5,000 to 200,000.
[5]
   The composition for temporary fixation according to any one of [1] to [4], in which the composition for temporary fixation contains the component (A-1), and the component (A-1) is one or more selected from the group consisting of a poly(butyl (meth)acrylate), a poly(ethyl (meth)acrylate), a poly(isoamyl (meth)acrylate), a poly(2-ethylhexyl (meth)acrylate), and a poly(isobornyl (meth)acrylate) that have an acryloyl group in a side chain.
[6]
   The composition for temporary fixation according to any one of [1] to [5], in which the composition for temporary fixation contains the component (A-2), and the component (A-2) is one or more selected from the group consisting of a poly(butyl (meth)acrylate), a poly(ethyl (meth)acrylate), a poly(isoamyl (meth)acrylate), a poly(2-ethylhexyl (meth)acrylate), and a poly(isobornyl (meth)acrylate) that have an acryloyl group at both ends of a molecular chain thereof.
[7]
   The composition for temporary fixation according to any one of [1] to [6], in which the component (B) is one or more selected from the group consisting of bis(2,4,6-trimethylbenzoyl)phenylphosphine oxide, 2,4,6-trimethylbenzoyldiphenylphosphine oxide, and 1-[9-ethyl-6-(2-methylbenzoyl)-9H-carbazol-3-yl]ethanone 1-(O-acetyloxime).
[8]
   The composition for temporary fixation according to any one of [1] to [7], in which the component (C) has one or more selected from the group consisting of a benzophenone skeleton, a triazole skeleton, a hydroxyphenyltriazine skeleton, and a phenol skeleton, and has a polymerizable functional group.
[9]
   The composition for temporary fixation according to any one of [1] to [8], containing 0.01 to 10 parts by mass of the component (B) and 0.01 to 15 parts by mass of the component (C), relative to 100 parts by mass of the total of the component (A).
[10]
   An adhesive for temporary fixation containing the composition for temporary fixation according to any one of [1] to [9].
[11]
   A method for producing a thin wafer using the adhesive for temporary fixation according to [10].
[12]
   A composition containing the following (A) to (C):
   (A) a polymerizable component containing the following (A-1) or (A-2):
   (A-1) a (meth)acrylate containing a (meth)acryloyl group in a side chain; and
   (A-2) a (meth)acrylate having a (meth)acryloyl group at both ends of a molecular chain thereof;
   (B) a polymerization initiator; and
   (C) an ultraviolet absorber having a polymerizable functional group.

### Advantageous Effects of Invention

According to an embodiment of the invention, it is possible to provide a composition for temporary fixation that can suppress re-adhesion. In another embodiment of the invention, it is possible to provide an adhesive for temporary fixation containing the aforementioned composition for temporary fixation, and a method for producing a thin wafer using the adhesive for temporary fixation.

### Description of Embodiments

Now, embodiments of the invention will be described in detail. It should be understood that the invention is not limited to the following embodiments, and that design changes and improvements are appropriately made based on common knowledge of those skilled in the art without departing from the gist of the invention.

Unless otherwise specified herein, numerical ranges are defined to include the upper and lower limits thereof. The (meth)acrylate herein refers to a compound having one or more (meth)acryloyl groups in a molecule. The monofunctional (meth)acrylate refers to a compound having a single (meth)acryloyl group in a molecule. The polyfunctional (meth)acrylate refers to a compound having two or more (meth)acryloyl groups in a molecule. The n-functional (meth)acrylate refers to a compound having n (meth)acryloyl groups in a molecule. The polymerizable functional group in a polyfunctional (meth)acrylate may have only an acryloyl group, only a methacryloyl group, or both an acryloyl group and a methacryloyl group.

In one embodiment, the invention provides a composition containing the following (A) to (C):
(A) a polymerizable component containing the following (A-1) or (A-2):
(A-1) a (meth)acrylate containing a (meth)acryloyl group in a side chain; and
(A-2) a (meth)acrylate having a (meth)acryloyl group at both ends of a molecular chain thereof;
(B) a polymerization initiator; and
(C) an ultraviolet absorber having a polymerizable functional group.

In one preferred embodiment, the invention provides a composition for temporary fixation containing the following (A) to (C):
(A) a polymerizable component containing the following (A-1) or (A-2):
(A-1) a (meth)acrylate containing an acryloyl group in a side chain; and
(A-2) a (meth)acrylate having an acryloyl group at both ends of molecular chain thereof;
(B) a photo-radical polymerization initiator; and
(C) an ultraviolet absorber having a polymerizable functional group.

### (1. Component (A))

The polymerizable component, which is the component (A) contained in the composition for temporary fixation in the embodiment, plays a role of forming a (meth) acrylic polymerization skeleton. The polymerizable component (A) includes the following component (A-1) and/or component (A-2), and may further optionally contain a polymerizable compound (e.g., polymerizable polymer) except the component (A-1) and the component (A-2).

The composition for temporary fixation of the embodiment may contain a non-polymerizable component, but the amount of the non-polymerizable component is preferably less than 15 parts by mass relative to 100 parts by mass of the total of the non-polymerizable component and the component (A). Note that, the term "non-polymerizable component" herein refers to a component having no polymerizable functional group such as a polymerizable double bond. Examples thereof include a non-polymerizable polymer. The components (A) to (C) are not included in the non-polymerizable component.

Note that, the (meth)acrylate (A-1) having an acryloyl group in a side chain in the embodiment can be rephrased as a polymerizable polymer (A-1) having an acryloyl group in a side chain. The (meth)acrylate (A-2) having an acryloyl group at both ends of a molecular chain thereof can be rephrased as a polymerizable polymer (A-2) having an acryloyl group at both ends of a molecular chain thereof.

The component (A-1) may be a (meth)acrylate containing an acryloyl group in a side chain, or a (meth)acrylate having two or more acryloyl groups in a side chain. The component (A-1) may be a monofunctional (meth)acrylate, a bifunctional (meth)acrylate, a polyfunctional (meth)acrylate having tri or more functional groups, or a mixture of these. Preferably, the component (A-1) may contain a combination of a polyfunctional (meth)acrylate and a monofunctional (meth)acrylate, a combination of a polyfunctional (meth)acrylate and a bifunctional (meth)acrylate, or a combination of a polyfunctional (meth)acrylate, a monofunctional (meth)acrylate, and a bifunctional (meth)acrylate.

A case where the component (A-1) is a (meth)acrylate containing an acryloyl group in a side chain means that an acryloyl group is present in a side chain of a molecular chain thereof. If a composition has no acryloyl group, the composition serves as a tackifier. Consequently, when a glass support comes into contact with a wafer by its own weight, re-adhesion likely occurs. However, when an acryloyl group is contained, the acryloyl group is polymerized during curing, with the result that the composition loses adhesive function. It is presumed that even when a glass support comes into contact with a wafer by its own weight, the occurrence of re-adhesion can be suppressed. However, the invention is not bound by any theory.

Examples of the (meth)acrylate having an acryloyl group in a side chain include a poly(butyl (meth)acrylate), a poly(ethyl (meth)acrylate), a poly(methyl (meth)acrylate), a poly(isoamyl (meth)acrylate),a poly(2-ethylhexyl (meth)acrylate), and a poly(isobornyl (meth)acrylate) that have an acryloyl group in a side chain. Of them, a poly(butyl (meth)acrylate), a poly(ethyl (meth)acrylate), a poly(methyl (meth)acrylate), and a poly(2-ethylhexyl (meth)acrylate) are preferable. A poly(butyl (meth)acrylate) is more preferable. Also, a commercially available (meth)acrylate containing an acryloyl group in a side chain may be used. For example, "HX7975" and "HX7975D" manufactured by Showa Denko Materials Co., Ltd., "EBECRYL305", "KRM8912", and "KRM8981" manufactured by Daicel-Allnex Ltd., and "RA-341", "RA-331P", "OAP-2531", "MAP-2801", "RA-4101", "MAP-7000", "MAP-4050", "RA-3631", and "OAP-5000" manufactured by Negami Chemical Industrial Co., Ltd., are preferable. A commercially available product diluted in a solvent is preferably used after the solvent is removed. "APB-001" manufactured by Negami Chemical Industrial Co., Ltd., is also preferable.

Note that, a poly(butyl (meth)acrylate) or the like containing an acryloyl group in a side chain mentioned as examples in the above means a polymer having a poly(butyl (meth)acrylate) as a skeleton and a part of the side chain modified with an acryloyl group.

The Tg of the component (A-1) is preferably -80°C to 0°C. If the Tg of the component (A-1) providing a resin having an appropriate hardness in the application of the invention is -80°C or more, a resin having hardness can be obtained. From the viewpoint, the Tg of the component (A-1) is more preferably -70°C or more, still more preferably -65°C or more, and still more preferably -60°C or more. If the Tg of the component (A-1) is 0°C or less, it is possible to obtain a resin that can be peeled off without breaking even when the temporary fixing agent is bent during peeling off. From the viewpoint, the Tg of the component (A-1) is more preferably -5°C or less, still more preferably -10°C or less, still more preferably -20°C or less, and particularly preferably -40°C or less.

The component (A-1) preferably has a weight average molecular weight of 5,000 to 200,000. If the weight average molecular weight of the component (A-1) is 5,000 or more, an appropriate viscosity can be obtained when the component is blended with other polymerizable components. If the weight average molecular weight of the component (A-1) is 10,000 or more, an appropriate thickening effect can be obtained. From the viewpoint, the weight average molecular weight of the component (A-1) is more preferably 6,000 or more, and still more preferably 7,000 or more. If the weight average molecular weight of the component (A-1) is 200,000 or less, good spin-coating property with low shear-rate dependency can be obtained. From the viewpoint, the weight average molecular weight of the component (A-1) is more preferably 190,000 or less, still more preferably 180,000 or less, still more preferably 150,000 or less, and particularly preferably 100,000 or less.

The functional-group equivalent of the component (A-1) is preferably 500 to 20,000, more preferably 700 to 10,000, and most preferably 1,000 to 7,000.

Note that, the weight average molecular weight herein is a standard polystyrene equivalent value measured by gel permeation chromatography (GPC). Specifically, the weight average molecular weight is obtained by preparing a calibration curve of a commercially available standard polystyrene using tetrahydrofuran as a solvent and GPC system (SC-8010 manufactured by Tosoh Corporation) under the following conditions.

Flow rate: 1.0 ml/min
Set temperature: 40°C
Column configuration: two columns of TSK-GEL MultiporeHXL-M φ7.8 × 300 mm (manufactured by Tosoh Corporation), exclusion limit 2 million
Sample injection amount: 100 µl (sample-liquid concentration 0.1% (wt/vol))
Liquid delivery pressure: 3.8 MPa
Detector: RI detector (differential refractive index detector)

Note that, the glass transition temperature (Tg) herein is measured by a differential scanning calorimeter (DSC). The intersection of a straight line, which is obtained by extending the baseline on the low temperature side of the DSC curve during temperature increasing time obtained by the measurement toward the high temperature side, and a tangent line, which is drawn at a point where the gradient of the stepwise change portion of the glass transition is a maximum, was determined as the glass temperature. Specific conditions of the apparatus are as follows. The glass transition temperature (Tg) herein was determined using the DSC value at the temperature increase (3).
Apparatus: EXSTAR6000 (manufactured by Hitachi High-Tech Science Corporation)
Temperature increase/decrease rate: 5°C/min

Temperature conditions: temperature was increased from room temperature to 40°C and held for 5 minutes (temperature increase (1)), the temperature was decreased from 40°C to -80°C and held for 5 minutes (temperature decrease (1)), the temperature was increased from -80°C to 50°C (temperature increase (2)), the temperature was decreased from 50°C to -80°C and held for 5 minutes (temperature decrease (2)), and then the temperature was increased from -80°C to 50°C (temperature increase (3)).

The component (A-2) is a (meth)acrylate having an acryloyl group at both ends of a molecular chain thereof. The component (A-2) may be a bifunctional (meth)acrylate, a polyfunctional (meth)acrylate having tri or more functional groups, or a mixture thereof. Preferably, the component (A-2) may contain a combination of a polyfunctional (meth)acrylate and a bifunctional (meth)acrylate.

Herein, it is important that the component (A-2) is a (meth)acrylate having an acryloyl group at both ends of a molecular chain thereof. If a composition has no acryloyl group, the composition serves as a tackifier. Consequently, when a glass support comes into contact with a wafer by its own weight, re-adhesion likely occurs. However, when an acryloyl group is contained, the acryloyl group is polymerized during curing, with the result that the composition loses adhesive function. As a result, it is presumed that even when a glass support comes into contact with a wafer by its own weight, the occurrence of re-adhesion can be suppressed. However, the invention is not bound by any theory.

Examples of the (meth)acrylate having an acryloyl group at both ends of a molecular chain thereof include a poly(butyl (meth)acrylate), a poly(ethyl (meth)acrylate), a poly(isoamyl (meth)acrylate), a poly(2-ethylhexyl (meth)acrylate), and a poly(isobornyl (meth)acrylate). Of them, a poly(butyl (meth)acrylate) having an acryloyl group at both ends of a molecular chain thereof is preferable. Also, the (meth)acrylate having an acryloyl group at both ends of a molecular chain thereof can be obtained by various polymerization methods. Although the methods are not particularly limited, radical polymerization methods are preferable in view of versatility of the monomer and ease of reaction control. Of the radical polymerizations, controlled radical polymerization is preferable, living radical polymerization is more preferable, and atom transfer radical polymerization is particularly preferable. Examples of the method for introducing a (meth) acrylic group into a polymer of a (meth) acrylic monomer as a main skeleton include (1) a method by a reaction of a vinyl polymer having a hydroxyl group at an end with chlorine, bromine, or a hydroxyl group-containing (meth)acrylate compound, (2) a method by a reaction of a vinyl polymer having halogen group at an end with an alkali metal ion or a quaternary ammonium ion-containing (meth)acrylate compound, and (3) a method by a reaction of a diisocyanate compound with a vinyl polymer having a hydroxyl group at an end followed by a reaction of a remaining isocyanate group with a hydroxyl group-containing (meth)acrylate. These methods are already known and disclosed in e.g., JP 61-133201 A, JP 11-80250 A, JP 2000-38404 A, JP 2001-271055 A, and JP 2002-69121 A.

Examples of the commercially available products include, but are not limited to, RC200C, RC110C, and RC100 manufactured by KANEKA CORPORATION.

The Tg of the component (A-2) is preferably -80°C to 0°C. If the Tg of the component (A-2) providing a resin having an appropriate hardness in the application of the invention is -80°C or more, a resin having hardness can be obtained. From this viewpoint, the Tg of the component (A-2) is more preferably -70°C or more, still more preferably -65°C or more, and still more preferably -60°C or more. If the Tg of the component (A-2) is 0°C or less, it is possible to obtain a resin that can be peeled off without breaking even when the temporary fixing agent is bent during peeling off. From this viewpoint, the Tg of the component (A-2) is more preferably -5°C or less, still more preferably -10°C or less, still more preferably -20°C or less, and particularly preferably -40°C or less.

The weight average molecular weight of the component (A-2) is preferably 5,000 to 200,000. If the weight average molecular weight of the component (A-2) is 5,000 or more, an appropriate viscosity can be obtained when the component is blended with other polymerizable components. If the weight average molecular weight of the component (A-2) is 10,000 or more, an appropriate thickening effect can be obtained. From this viewpoint, the weight average molecular weight of the component (A-2) is more preferably 6,000 or more, and still more preferably 7,000 or more. If the weight average molecular weight of the component (A-2) is 200,000 or less, good spin-coating property with low shear-rate dependency can be obtained. From this viewpoint, the weight average molecular weight of the component (A-2) is more preferably 190,000 or less, still more preferably 180,000 or less, still more preferably 150,000 or less, still more preferably 100,000 or less, still more preferably 50,000 or less, and particularly preferably 30,000 or less.

The functional-group equivalent of the component (A-2) is preferably 500 to 20,000, more preferably 700 to 10,000, and most preferably 1,000 to 7,000.

Note that, the polymerizable compound herein refers to a polymerizable component having a (meth)acryloyl group except the component (A-1) and the component (A-2). The polymerizable compound is preferably a monofunctional (meth)acrylate, a bifunctional (meth)acrylate, a polyfunctional (meth)acrylate having tri or more functional groups, or a polymerizable polymer. Examples of the polymerizable polymer include urethane acrylate and epoxy acrylate.

In a preferred embodiment, the sum of the component (A-1) and the component (A-2) in the component (A) may fall within the range of 10 to 100 mass% relative to the total mass of the component (A). Specifically, the sum of the component (A-1) and the component (A-2) is preferably 10 mass% or more, 15 mass% or more, 20 mass% or more, 25 mass% or more, or 30 mass% or more relative to the total mass of the component (A). The sum of the component (A-1) and the component (A-2) may be preferably 100 mass% or less, 90 mass% or less, 80 mass% or less, 70 mass% or less, 60 mass% or less, 50 mass% or less, or 40 mass% or less relative to the total mass of the component (A).

In a preferred embodiment, the mass ratio of the sum of the component (A-1) and the component (A-2) in the component (A) relative to the polymerizable compound may fall within the range of 1 to 50 : 100. In another embodiment, the component (A) includes both the component (A-1) and the component (A-2), and the mass ratio of the component (A-1), the component (A-2), and the polymerizable polymer may fall within the range of 5 to 20 : 5 to 30 : 100. Note that, when a compound corresponding to both the component (A-1) and the component (A-2) is contained, the compound is not redundantly added.

The content of the component (A-1) may be preferably 0 to 100 mass% relative to 100 mass% of the total amount of the component (A). Specifically, the content of the component (A-1) is preferably 0 mass% or more, 25 mass% or more, 40 mass% or more, 55 mass% or more, or 80 mass% or more, relative to 100 mass% of the total amount of the component (A). The content of the component (A-1) is preferably 100 mass% or less, 85 mass% or less, 60 mass% or less, or 40 mass% or less relative to 100 mass% of the total amount of the component (A).

The content of the component (A-2) may be preferably 0 to 100 mass% relative to 100 mass% of the total amount of the component (A). Specifically, the content of the component (A-1) is preferably 0 mass% or more, 10 mass% or more, 25 mass% or more, 40 mass% or more, or 55 mass% or more, relative to 100 mass% of the total amount of the component (A). The content of the component (A-1) is preferably 100 mass% or less, 85 mass% or less, 60 mass% or less, or 40 mass% or less relative to 100 mass% of the total amount of the component (A).

The content of another polymerizable compound (A-3) except the component (A-1) and the component (A-2) may be preferably 50 to 99 mass% relative to the total amount of the component (A). Specifically, the content of the component (A-1) is preferably 50 mass% or more, 55 mass% or more, 60 mass% or more, or 65 mass% or more relative to 100 mass% of the total amount of the component (A). The content of the component (A-1) is preferably 99 mass% or less, 95 mass% or less, 90 mass% or less, or 85 mass% or less relative to 100 mass% of the total amount of the component (A).

In a preferred embodiment, the amount of the non-polymerizable component contained in the composition for temporary fixation in the embodiment may be 0 mass% or more and less than 10 mass%, or 0 mass% or more and less than 5 mass%. More preferably, the non-polymerizable component may not be contained.

Examples of the polymerizable compound (A-3) except the polymerizable polymers (A-1) and (A-2) include an aromatic bifunctional (meth)acrylate, an alicyclic bifunctional (meth)acrylate, and an acyclic bifunctional (meth)acrylate.

Examples of the aromatic bifunctional (meth)acrylate preferably include 9,9-bis[4-(2-hydroxyethoxy)phenyl] fluorene di(meth)acrylate, ethoxylated bisphenol A di(meth)acrylate, benzyl di(meth)acrylate, 1,3-bis(2-(meth)acryloyloxy C₁ to C₂₀ alkyl) benzene, and 2,2-bis(4-(meth) acryloxydiethoxyphenyl) propane. Preferably, a di(meth)acrylate having a fused ring skeleton, for example, fluorene, indene, indecene, anthracene, azulene, or triphenylene skeleton may be contained.

Examples of the alicyclic bifunctional (meth)acrylate include EO (ethylene oxide) modified hydrogenated bisphenol A di(meth)acrylate, 1,3-di(meth)acryloyloxyadamantane, tricyclo C₁₀ to C₂₀ alkanedimethanol di(meth)acrylate, and dicyclo C₅ to C₂₀ di(meth)acrylate.

Examples of the acyclic bifunctional (meth)acrylate include 1,3-butanediol di(meth)acrylate, 1,4-butanediol di(meth)acrylate, 1,6-hexanediol di(meth)acrylate, 1,9-nonanediol di(meth)acrylate, 1,10 decanediol di(meth)acrylate, neopentyl glycol di(meth)acrylate, caprolactone-modified hydroxypivalic acid neopentyl glycol di(meth)acrylate, and trimethylolpropane di(meth)acrylate.

Of them, it is more preferable to contain at least 9,9-bis[4-(2-hydroxyethoxy)phenyl]fluorene di(meth)acrylate, and it is still more preferable to contain at least 9,9-bis[4-(2-hydroxyethoxy)phenyl]fluorene di(meth)acrylate and ethoxylated bisphenol A di(meth)acrylate.

Of them, it is more preferable to contain at least 9,9-bis[4-(2-hydroxyethoxy)phenyl]fluorene diacrylate, and it is still more preferable to contain at least 9,9-bis[4-(2-hydroxyethoxy)phenyl]fluorene diacrylate and ethoxylated bisphenol A diacrylate.

### (2. Component (B))

The polymerization initiator, preferably the photo-radical polymerization initiator, which is the component (B) contained in the composition for temporary fixation in the embodiment is a substance that can initiate polymerization of the component (A) upon light irradiation. The photo-radical polymerization initiator refers to, for example, a compound whose molecule is cleaved by irradiation with ultraviolet rays or visible light (having, for example, a wavelength of 350 to 700 nm, preferably 365 to 500 nm, more preferably 385 to 450 nm) into two or more radicals. Examples of the photo-radical polymerization initiator include bis(2,4,6-trimethylbenzoyl)phenylphosphine oxide, 2,4,6-trimethylbenzoyldiphenylphosphine oxide, bis(η5-2,4-cyclopentadien-1-yl)-bis(2,6-difluoro-3-(1H-pyrrol-1-yl)-phenyl) titanium, 2-benzyl-2-dimethylamino-1-(4-morpholinophenyl)-butan-1-one, 2-dimethylamino-2-(4-methylbenzyl)-1-(4-morpholin-4-ylphenyl)-butan-1-one, 1-[4-(phenylthio)phenyl]-1,2-octanedione 2-O-benzoyloxime, and 1-[9-ethyl-6-(2-methylbenzoyl)-9H-carbazol-3-yl]ethanone 1-(O-acetyloxime). The component (B) may include a combination of one or more or two or more of these.

In a preferred embodiment of the invention, the component (B) contained in the composition for temporary fixation may contain an acylphosphine oxide compound. Examples of preferred acylphosphine oxide compounds include bis(2,4,6-trimethylbenzoyl)phenylphosphine oxide and 2,4,6-trimethylbenzoyldiphenylphosphine oxide. The photo-radical polymerization initiator preferably has high sensitivity and excellent deep curability since it has a light fading property, and in addition, an absorption wavelength region for generating radicals is wide up to a relatively long wavelength region. The preferred compound described above has an absorption wavelength region up to about 440 nm, which greatly differs from the absorption wavelength region of the UV absorber used in the UV laser peeling step described later. That is, the degree of inhibiting UV curing by the UV absorber is small, and radical polymerization can be initiated by light having a longer wavelength. Therefore, it is possible to obtain an effect that radical polymerization can be efficiently initiated to cure at a relatively high speed even in the presence of a UV absorber.

In a preferred embodiment, the photo-radical polymerization initiator can be selected based on absorbance. Specifically, a photo-radical polymerization initiator can be selected from one or more of compounds that satisfy any one or more of the following conditions: the absorbance at a wavelength of 365 nm is 0.5 or more; the absorbance at a wavelength of 385 nm is 0.5 or more; and the absorbance at a wavelength of 405 nm is 0.5 or more when dissolved at a concentration of 0.1 mass% in a solvent having no maximum absorption in a wavelength region of 300 to 500 nm (for example, acetonitrile or toluene). Examples of the compound satisfying such conditions include 1-[9-ethyl-6-(2-methylbenzoyl)-9H-carbazol-3-yl]ethanone 1-(O-acetyloxime) having an absorbance of 0.5 or more at a wavelength of 365 nm when dissolved at a concentration of 0.1 mass% relative to acetonitrile as a solvent, 1-[4-(phenylthio)phenyl]-1,2-octanedione 2-O-benzoyloxime having an absorbance of 0.5 or more at wavelengths of 365 nm and 385 nm, bis(2,4,6-trimethylbenzoyl)phenylphosphine oxide and 2,4,6-trimethylbenzoyldiphenylphosphine oxide having an absorbance of 0.5 or more at wavelengths of 365 nm, 385 nm, and 405 nm.

In view of achieving both curability by the photo-radical polymerization initiator and peeling by UV laser, bis(η5-2,4-cyclopentadien-1-yl)-bis(2,6-difluoro-3-(1H-pyrrol-1-yl)-phenyl)titanium having an absorption in the wavelength range of 400 to 500 nm can also be used as the photo-radical polymerization initiator.

The photo-radical polymerization initiator (B) is preferably one or more selected from the group consisting of an acylphosphine oxide compound, a titanocene compound, and an α-aminoalkylphenone compound in view of a reaction rate, heat resistance after curing, low-outgassing characteristics, and absorption characteristics in a region different from not only the wavelength region of a UV laser but also the absorption wavelength region of a UV absorber used for the UV laser peeling described later. As the photo-radical polymerization initiator for a resin composition, which is use for temporary fixation to prevent breakage during a process from adhesion to a heating step of a support base-material (or support) for a base-material to be processed (which is not a layer corresponding to the UV laser peeling step), and which is contained in the composition for temporary fixation having a structure described later, an oxime ester compound can also be selected other than above compounds.

Examples of the acylphosphine oxide compound include bis(2,4,6-trimethylbenzoyl)phenylphosphine oxide and 2,4,6-trimethylbenzoyldiphenylphosphine oxide. Of them, bis(2,4,6-trimethylbenzoyl)phenylphosphine oxide is particularly preferable.

Examples of the titanocene compound include bis(η5-2,4-cyclopentadien-1-yl)-bis(2,6-difluoro-3-(1H-pyrrol-1-yl)-phenyl)titanium.

Examples of the α-aminoalkylphenone compound include 2-benzyl-2-dimethylamino-1-(4-morpholinophenyl)-butan-1-one and 2-dimethylamino-2-(4-methylbenzyl)-1-(4-morpholin-4-ylphenyl)-butan-1-one.

Examples of the oxime ester compound include 1-[4-(phenylthio)phenyl]-1,2-octanedione 2-O-benzoyloxime, and 1-[9-ethyl-6-(2-methylbenzoyl)-9H-carbazol-3-yl]ethanone 1-(O-acetyloxime). Of them, 1-[9-ethyl-6-(2-methylbenzoyl)-9H-carbazol-3 yl]ethanone 1-(O-acetyloxime) is preferable.

In a preferred embodiment of the invention, the component (B) in the composition for temporary fixation is one or more selected from the group consisting of bis(2,4,6-trimethylbenzoyl)phenylphosphine oxide, 2,4,6-trimethylbenzoyldiphenylphosphine oxide, and 1-[9-ethyl-6-(2-methylbenzoyl)-9H-carbazol-3-yl]ethanone 1-(O-acetyloxime).

The amount of the photo-radical polymerization initiator (B) to be used is preferably 0.01 to 10 parts by mass, more preferably 0.01 to 5 parts by mass, still more preferably 0.1 to 2 parts by mass, and still more preferably 0.1 to 1 part by mass, relative to 100 parts by mass of the total of the component (A), in view of reaction rate, heat resistance after curing, and low-outgassing characteristics. If the component (B) is 0.01 part by mass or more, sufficient curability can be obtained, whereas if the component is 10 parts by mass or less, less outgassing characteristics and heat resistance are less likely to be damaged.

### (3. Component (C))

The component (C) contained in the composition for temporary fixation in the embodiment, that is, an ultraviolet absorber (UV absorber) having a polymerizable functional group, refers to a compound, whose molecule is cleaved by irradiation with ultraviolet-ray or a visible-ray laser, and decomposed/vaporized to cause a loss of the adhesiveness maintained between the temporary fixing agent and the support base-material (or support) until immediately before the UV laser peeling step, since the decomposition/vaporization occurs at the interface between the support base-material (or support) and the temporary fixing agent. The component (C) is a compound having one or more selected from the group consisting of a benzophenone skeleton, a triazole skeleton, a hydroxyphenyltriazine skeleton, and a phenol skeleton (preferably a hindered phenol skeleton). The reason why a compound has such a skeleton is to obtain the degree of overlap with the UV laser wavelength in the UV absorption wavelength region, UV absorption characteristics at the wavelength, less outgassing, and heat resistance. The polymerizable functional group that the component (C) has is preferably a (meth)acryloyl group.

As an example of the component (C), one or more selected from the group consisting of 2-[2-hydroxy-5-[2-((meth)acryloyloxy)ethyl]phenyl]-2H-benzotriazole, 2-[1-(2-hydroxy-3,5-di-tert-pentylphenyl)ethyl]-4,6-di-tert-pentylphenyl (meth)acrylate, 2-(2-(meth)acryloyloxy, 5-methyl)phenyl-2H-benzotriazole, 1,1-bis-[2-(meth)acryloyloxy, 3-(2H-benzotriazol-2-yl), 5-tertiary octyl]methane, and 2,2'-dihydroxy-4,4'-di(meth)acryloyloxybenzophenone are particularly preferable in view of compatibility with a resin component, UV absorption characteristics, low-outgassing characteristics, and heat resistance.

The amount of the component (C) is preferably 0.01 to 15 parts by mass, more preferably 0.1 to 10 parts by mass, still more preferably 0.5 to 9.5 parts by mass, and still more preferably 0.5 to 7 parts by mass, relative to 100 parts by mass of the total of component (A). If the content is 0.01 part by mass or more, a sufficient UV laser peeling rate can be obtained, whereas, if the content is 15 parts by mass or less, low-outgassing characteristics and heat resistance are likely to be damaged.

### (4. Adhesive for Temporary Fixation)

The composition for temporary fixation of the invention can be used as an adhesive for temporary fixation, particularly an adhesive for temporary fixation of a thin wafer in producing an electronic device. The adhesive for temporary fixation preferably consists only of the composition for temporary fixation of the invention.

### (5. Method for Producing Thin Wafer)

In another embodiment of the invention, a method for producing a thin wafer using the adhesive for temporary fixation of the invention is also provided. The method includes applying an adhesive for temporary fixation to a support base-material (or a support), allowing a base-material to be processed to bond to the surface of the support base-material (or a support) having the adhesive for temporary fixation applied, thinning the base-material to be processed, and peeling off the support base-material (or a support) and the base-material to be processed by irradiation of UV laser.

As a method for applying an adhesive for temporary fixation, an application method commonly known, such as spin coating, screen printing, and various coaters can be used. The viscosity of the composition for temporary fixation of the embodiment is preferably 500 mPa·s or more, more preferably 1000 mPa·s or more in view of coating properties and workability at 23°C (under atmospheric pressure). The viscosity of the composition for temporary fixation of the embodiment is preferably 15,000 mPa·s or less, more preferably 10,000 mPa·s or less, and still more preferably 5,000 mPa·s or less in view of coating properties and workability at 23°C (under atmospheric pressure). If the viscosity is 500 mPa·s or more, coating properties, particularly coating properties by spin coating can be excellent. If the viscosity is 15,000 mPa·s or less, workability can be excellent. The viscosity can be measured by a viscometer commonly known.

The spin coating is a method of applying a liquid composition to the surface of, for example, a support base-material (or support) by adding the liquid composition dropwise to a support base-material (or support), and rotating the support base-material (or support) at a predetermined rotation speed. A high-quality coating film can be efficiently produced by spin coating.

When the base-material to be processed and the support base-material (or a support) are bonded, it is preferable that visible light or ultraviolet light is applied so as to obtain an energy amount of 1 to 20,000 mJ/cm² (in wavelength or central wavelength 365 to 405 nm). If the energy amount is 1 mJ/cm² or more, sufficient adhesiveness can be obtained, whereas if the energy amount is 20,000 mJ/cm² or less, productivity can be excellent, a decomposition product is less likely to be produced from the photo-radical polymerization initiator, and outgassing can be suppressed. The energy amount is preferably 1,000 to 10,000 mJ/cm² in view of productivity, adhesiveness, less outgassing, and easy-to-peel property.

The base-material to be processed and the support base-material (or support) are not particularly limited, but at least one of the base-materials is preferably a transparent base-material that transmits light. Examples of the transparent base-material include an inorganic material of, e.g., crystal, glass, quartz, calcium fluoride, and magnesium fluoride, and an organic base-material of, e.g., plastic. Of them, an inorganic material is preferable because it is commonly used and a large effect can be obtained. Of the inorganic base-materials, one or more selected from the group consisting of glass and quartz are preferable.

After the base-material to be processed is subjected to thinning processing by grinding/polishing and a high-temperature processing, peeling-off can be made by irradiating the entire surface on the optically transparent base-material side of the composite body with a UV laser in a scanning manner. As described above, since the re-adhesion between a support and a thin wafer is suppressed by use of the composition for temporary fixation of the invention, even if there is a time interval between the irradiation with the UV laser and a peeling step, workability can be prevented from decreasing.

### Examples

Hereinafter, the invention will be described in more detail based on Examples and Comparative Example, but the invention is not limited thereto.

Unless otherwise specified, the experiment was performed at 23°C and a humidity of 50%. Compositions for temporary fixation (hereinafter, sometimes referred to as liquid compositions) having the formulas (unit: part(s) by mass) shown in the following table were prepared and evaluated. As individual components, the following compounds were selected.

### (Synthesis of Compound: α-1)

A 2 L four-necked round-bottom flask was charged with ethyl acetate and azobisisobutyronitrile (AIBN). While refluxing the mixture, n-butyl acrylate (BA) and 2-hydroxyethyl acrylate (2HEA) were added dropwise to the mixture over 2 hours, and then ethyl acetate and AIBN were further added thereto. The mixture was reacted for 7.5 hours to obtain a hydroxyl group-containing acrylic resin (α-0) solution (the monomer composition of the hydroxyl group-containing acrylic resin (α-0) is BA: 2HEA = 90 : 10 (molar ratio), and the solid content is 40 wt%).

To the hydroxyl group-containing acrylic resin (α-0) and 99 mol% of 2-isocyanatoethyl acrylate (AOI) relative to 100 mol% of 2HEA in the hydroxyl group-containing acrylic resin (α-0), and dibutyltin dilaurate as a urethane catalyst were appropriately added. After the mixture was reacted at 50°C for 18 hours with stirring, ethyl acetate was removed to obtain an acrylic resin (α-1) containing a plurality of acryloyl groups in a side chain.

### (Identification of Compound)

The obtained α-1 was dissolved in deuterated chloroform (reagent grade manufactured by Tokyo Chemical Industry Co., Ltd.) to prepare a 3 mass% solution, which was then subjected to 1H-nuclear magnetic resonance measurement (1H-NMR). The obtained data were as follows.

δ = 6.45 to 6.40, 6.16 to 6.09, 5.85 to 5.83, 4.25 to 4.23, 4.03 to 4.02, 3.52 to 3.48, 2.27, 1.90, 1.59, 1.38 to 1.34, 0.95 to 0.15

The structure of α-1 was supported by the above results.

### (Synthesis of Compound: α-2)

A 100 mL three-necked round-bottom flask equipped with a reflux tube was charged with cuprous bromide (0.625 g, 15.6 mmol), acetonitrile (5.0 mL), and pentamethyldiethylenetriamine (0.91 mL), and purged with nitrogen gas. Then, n-butyl acrylate (50 mL, 44.7 g, 0.39 mol) and diethyl-2,5-dibromoadipate (1.57 g, 4.36 mmol) were added. The mixture was heated and stirred at 70°C for 7 hours. The mixture was diluted with ethyl acetate and treated with activated alumina. The volatile matter was distilled off under reduced pressure to obtain poly(n-butyl acrylate) having halogen at the both ends. Next, a 200 mL three-necked round-bottom flask equipped with a reflux tube was charged with the poly(butyl acrylate) (35.0 g) having halogen at the ends obtained as described above, a potassium salt of 4-pentenoic acid (2.23 g, 16.1 mmol), and dimethylacetamide (35 mL). The mixture was reacted at 70°C for 4 hours under a nitrogen atmosphere. The mixture was diluted with ethyl acetate and washed with 2% hydrochloric acid and brine. The organic layer was dried over Na₂SO₄, and the volatile matter was distilled off under reduced pressure to isolate a polymer. Aluminum silicate (KYOWAAD 700PEL manufactured by Kyowa Chemical Industry Co., Ltd.) was added in the equivalent amount as the polymer. The mixture was stirred at 100°C for 4 hours to obtain poly(n-butyl acrylate) (α-2) having an acryloyl group at both ends.

### (Composition)

As the component (A-1), the following were used.
APB-001 (polyfunctional acrylate polymer: "APB-001" manufactured by Negami Chemical Industrial Co., Ltd., weight average molecular weight: 72,000, functional-group equivalent: 1,400, Tg: -45°C)
Synthesized Polymer α-1 (polyfunctional acrylate polymer, weight average molecular weight: 78,000, Tg: - 50°C)

As the component (A-2), the following were used.
RC110C (both-end acrylate polymer, "RC110C" manufactured by KANEKA CORPORATION, weight average molecular weight: 12,000, functional-group equivalent: 6,000, Tg: -50°C)
Synthesized Polymer α-2 (both end acrylate polymer, weight average molecular weight: 12,000, Tg: -54°C)

As other polymerizable polymers, the following were used.
A-BPEF-2: 9,9-bis[4-(2-hydroxyethoxy)phenyl]fluorene diacrylate ("NK Ester A-BPEF-2" manufactured by Shin Nakamura Chemical Co., Ltd.)
A-BPE-2: ethoxylated bisphenol A diacrylate ("NK Ester A-BPE-2" manufactured by Shin Nakamura Chemical Co., Ltd., in the following structural formula, R = -CH₂CH₂O-, m = n = 1) 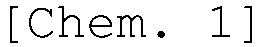 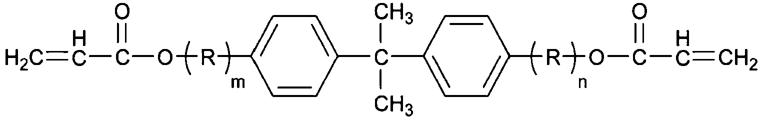
HBPE-4: EO-modified hydrogenated bisphenol A diacrylate ("HBPE-4" manufactured by DKS Co. Ltd., m + n ≈ 4)
A-DOD-N: 1,10-decanediol diacrylate ("A-DOD-N" manufactured by Shin-Nakamura Chemical Co., Ltd.)
HX-620: caprolactone-modified neopentylglycol hydroxypivalate diacrylate ("KAYARAD HX-620" manufactured by Nippon Kayaku Co., Ltd., m + n ≈ 4)
HX-220: caprolactone-modified neopentylglycol hydroxypivalate diacrylate ("KAYARAD HX-220" manufactured by Nippon Kayaku Co., Ltd., m + n ≈ 2)
A-TMPT: trimethylolpropane triacrylate ("A-TMPT" manufactured by Shin-Nakamura Chemical Co., Ltd.)
M-113: Nonylphenol EO-modified acrylate ("ARONIX M-113" manufactured by Toagosei Co., Ltd., n ≈ 4)
ISTA: isostearyl acrylate ("ISTA" manufactured by OSAKA ORGANIC CHEMICAL INDUSTRY LTD.)

As the component (B), bis(2,4,6-trimethylbenzoyl)phenylphosphine oxide ("Omnirad 819" manufactured by IGM RESINS) was used.

The following were used as component (C).
RUVA-93: 2-[2-hydroxy-5-[2-(methacryloyloxy)ethyl]phenyl]-2H-benzotriazole ("RUVA-93" manufactured by Otsuka Chemical Co., Ltd.)
P-66: 2,2'-dihydroxy-4,4'-diacryloyloxybenzophenone ("DAINSORB P-66" manufactured by Daiwa Fine Chemicals Co., Ltd.)

Note that, the weight average molecular weight of each of the components was determined by preparing a calibration curve of a commercially available standard polystyrene using tetrahydrofuran as a solvent and GPC system (SC-8010 manufactured by Tosoh Corporation) under the following conditions.

Flow rate: 1.0 ml/min
Set temperature: 40°C
Column configuration: two columns of TSK-GEL MultiporeHXL-M φ7.8 × 300 mm (manufactured by Tosoh Corporation), exclusion limit 2 million
Sample injection amount: 100 µl (sample-liquid concentration 0.1% (wt/vol))
Liquid delivery pressure: 3.8 MPa
Detector: RI detector (differential refractive index detector)

The glass transition temperature (Tg) of each of the components was measured by a differential scanning calorimeter (DSC). The intersection of a straight line, which is obtained by extending the baseline on the low temperature side of the DSC curve during temperature increasing time obtained by the measurement toward the high temperature side, and a tangent line, which is drawn at a point where the gradient of the stepwise change portion of the glass transition is a maximum, was determined as the glass temperature. Specific conditions of the apparatus are as follows. The glass transition temperature (Tg) was determined using the DSC value at the temperature increase (3).
Apparatus: EXSTAR6000 (manufactured by Hitachi High-Tech Science Corporation)
Temperature increase/decrease rate: 5°C/min

Temperature conditions: temperature was increased from room temperature to 40°C and held for 5 minutes (temperature increase (1)), the temperature was decreased from 40°C to -80°C and held for 5 minutes (temperature decrease (1)), the temperature was increased from -80°C to 50°C (temperature increase (2)), the temperature was decreased from 50°C to -80°C and held for 5 minutes (temperature decrease (1)), and then the temperature was increased from -80°C to 50°C (temperature increase (3)).

### (Preparation of Liquid Sample)

As shown in Table 1, in each of Comparative Example and Examples, materials were warmed and mixed at 60°C to obtain a composition for temporary fixation as a homogeneous liquid composition. The viscosity of each of the compositions was measured by the method according to JIS Z 8803:2011 as follows. The results are shown in Table 1.

### (Evaluation of Viscosity)

Measuring apparatus: type-E viscometer DV3T-HB (manufactured by EKO Instruments Co., Ltd.)
Measuring jig: Cone plate CPA-40Z (manufactured by EKO Instruments Co., Ltd.)
Measurement temperature: 23°C
Rotation speed: 10 rpm (500 mPa·s to 2,500 mPa·s); 2 rpm (2,501 mPa·s to 10,000 mPa·s)

### (Fabrication of bonding sample)

A 4-inch silicon wafer (10 cm in diameter × 0.47 mm in thickness) and a 4 inch glass support (10 cm in diameter × 0.7 mm in thickness) were bonded with each of the prepared liquid compositions. In bonding, the thickness of the liquid composition was adjusted so as to be 50 µm. After bonding, curing was made by an LED having a wavelength of 405 nm under the condition of an integrated light amount of 5,000 mJ/cm² to prepare test pieces for evaluating adhesiveness under a high temperature condition. The liquid composition was applied to the entire surface of the bonding surface.

### (Evaluation of Re-adhesion)

The glass support side of the obtained test piece was irradiated with UV laser. As the UV laser, a UV laser QLA-355 manufactured by Quark Technologies was used at an output of 8.5 W, a frequency of 40 kHz, a scan pitch of 200 µm, and a beam diameter of 200 µm. Then, after a predetermined time, the peel strength was measured in accordance with the following method.

A razor blade was brought into contact with a circumferential portion of the test piece irradiated with laser and a protruding portion from the circumferential portion was removed. The test piece was placed on a porous chuck type suction table such that the silicon wafer surface thereof faced down and fixed. Onto the glass surface of the test piece, three suckers having a diameter of 30 mm were attached and a load measuring module was attached to the suckers, and lifted vertically upward. In this manner, the load for peeling glass was measured. A plurality of test samples was prepared for each of Comparative Example and Examples. The time required for obtaining a peel strength of 15 N or more was defined as the time to re-adhesion.

**[Table 1]**

| | | Comparative Example | Example 1 | Example 2 | Example 3 | Example 4 | Example 5 | Example 6 | Example 7 | Example 8 |
|---|---|---|---|---|---|---|---|---|---|---|
| (A-1) | α-1 | | | | | 15 | 10 | 15 | 25 | |
| | APB-001 | | | | 15 | | | | | |
| (A-2) | α-2 | | | | | | 20 | 15 | 5 | 25 |
| | RC110C | - | 15 | 30 | | | | | | |
| Other polymerizable compounds | A-BPEF-2 | 10 | 10 | 10 | 10 | 10 | 10 | 10 | 10 | 10 |
| | A-BPE-2 | 22.5 | 22.5 | 22.5 | | | 15 | 15 | 15 | 20 |
| | HBPE-4 | | | | 25 | 25 | | | | |
| | A-DOD-N | | | | 10 | 10 | | | | |
| | HX-620 | 67.5 | 52.5 | 37.5 | | | | | | |
| | HX-220 | | | | | | 7.5 | 7.5 | 7.5 | |
| | A-TMPT | | | | | | 7.5 | 7.5 | 7.5 | 10 |
| | M-113 | | | | 10 | 10 | 10 | 10 | 10 | 10 |
| | ISTA | | | | 30 | 30 | 20 | 20 | 20 | 25 |
| (B) | Omnirad 819 | 1 | 1 | 1 | 1.5 | 1.5 | 1.5 | 1.5 | 1.5 | 1.5 |
| (C) | RUVA-93 | 5 | 5 | 5 | 3.5 | 3.5 | 3.5 | 3.5 | 3.5 | 5.0 |
| | P-66 | 4 | 4 | 4 | 5.5 | 5.5 | 6.0 | 6.0 | 6.0 | 4.0 |
| Evaluation results | Viscosity (mPa·s) | 900 | 2040 | 4594 | 1400 | 1300 | 4100 | 5500 | 9900 | 1500 |
| | Time to re-adhesion | <10 seconds | 40 seconds | 30 seconds | 180 seconds | 180 seconds | 180 seconds | 180 seconds | 210 seconds | 120 seconds |

The unit of the amount used is parts by mass.

From the results in Table 1, it is found that the composition for temporary fixation of the invention took a long time up to re-adhesion and exhibited good workability.

On the other hand, in Comparative Example containing neither the component (A-1) nor the component (A-2), it is found that the time up to re-adhesion is short, and the workability decreases depending on the working conditions.

## Claims

1. A composition for temporary fixation comprising the following (A) to (C):
(A) a polymerizable component containing the following (A-1) or (A-2):
(A-1) a (meth)acrylate containing an acryloyl group in a side chain; and
(A-2) a (meth)acrylate having an acryloyl group at both ends of a molecular chain thereof;
(B) a photo-radical polymerization initiator; and
(C) an ultraviolet absorber having a polymerizable functional group.

2. The composition for temporary fixation according to claim 1, wherein the composition for temporary fixation has a viscosity of 500 mPa·s to 15,000 mPa·s.

3. The composition for temporary fixation according to claim 1 or 2, wherein the component (A-1) or (A-2) has a Tg of -80 to 0°C.

4. The composition for temporary fixation according to claim 1 or 2, wherein the component (A-1) or the component (A-2) has a weight average molecular weight of 5,000 to 200,000.

5. The composition for temporary fixation according to claim 1 or 2, wherein the composition for temporary fixation contains the component (A-1), and the component (A-1) is one or more selected from the group consisting of a poly(butyl (meth)acrylate), a poly(ethyl (meth)acrylate), a poly(isoamyl (meth)acrylate), a poly(2-ethylhexyl (meth)acrylate), and a poly(isobornyl (meth)acrylate) that have an acryloyl group in a side chain.

6. The composition for temporary fixation according to claim 1 or 2, wherein the composition for temporary fixation contains the component (A-2), and the component (A-2) is one or more selected from the group consisting of poly(butyl (meth)acrylate), poly(ethyl (meth)acrylate), poly(isoamyl (meth)acrylate), poly(2-ethylhexyl (meth)acrylate), and poly(isobornyl (meth)acrylate) having an acryloyl group at both ends of a molecular chain thereof.

7. The composition for temporary fixation according to claim 1 or 2, wherein the component (B) is one or more selected from the group consisting of bis(2,4,6-trimethylbenzoyl)phenylphosphine oxide, 2,4,6-trimethylbenzoyldiphenylphosphine oxide, and 1-[9-ethyl-6-(2-methylbenzoyl)-9H-carbazol-3-yl]ethanone 1-(0-acetyloxime).

8. The composition for temporary fixation according to claim 1 or 2, wherein the component (C) has one or more selected from the group consisting of a benzophenone skeleton, a triazole skeleton, a hydroxyphenyltriazine skeleton, and a phenol skeleton, and has a polymerizable functional group.

9. The composition for temporary fixation according to claim 1 or 2, comprising 0.01 to 10 parts by mass of the component (B) and 0.01 to 15 parts by mass of the component (C), relative to 100 parts by mass of the total of the component (A).

10. An adhesive for temporary fixation comprising the composition for temporary fixation according to claim 1 or 2.

11. A method for producing a thin wafer using the adhesive for temporary fixation according to claim 10.

12. A composition containing the following (A) to (C):
(A) a polymerizable component containing the following (A-1) or (A-2):
(A-1) a (meth)acrylate containing a (meth)acryloyl group in a side chain; and
(A-2) a (meth)acrylate having a (meth)acryloyl group at both ends of a molecular chain thereof;
(B) a polymerization initiator; and
(C) an ultraviolet absorber having a polymerizable functional group.
